# EUROPEAN PATENT APPLICATION

(11) **EP 3 038 125 A1**
(43) Date of publication of application: **29.06.2016**
(21) Application number: 14307127.2
(22) Date of filing: 22.12.2014
(51) Int. Cl.: H01H 59/00

(54) **Mems structure with multilayer membrane**

(71) Applicant: DelfMEMS SAS, 59650 Villeneuve d'Ascq (FR)
(72) Inventor: Robin, Renaud, 59890 Quesnoy sur Deûle (FR); Lorphelin, Nicolas, 38500 Voiron (FR); Segueni, Karim, 59170 Croix (FR)
(74) Representative: Grünecker Patent- und Rechtsanwälte PartG mbB

(57) **Abstract**

The present invention relates to a method of manufacturing an MEMS device, in particular, an MEMS switch, comprising the steps of forming posts and a conduction (transmission) line over a substrate and forming a membrane over the posts and the conduction line comprising forming a first membrane layer and a second membrane layer over the first membrane layer in a region over one of the posts and/or a region over the conduction line such that the first membrane layer has a region where the second membrane layer is not formed adjacent to the region where the second membrane layer is formed. Moreover, it is provided an MEMS device, in particular, an MEMS switch, comprising posts and a conduction (transmission) line formed over a substrate and a membrane over the posts and the conduction line. The membrane comprises a first membrane layer and a second membrane layer formed over the first membrane layer in a region over one of the posts and/or a region over the conduction line such that the first membrane layer has a region where the second membrane layer is not formed adjacent to the region where the second membrane layer is formed.

## Description

### Field of Invention

The present invention relates to Micro-Electromechanical Systems (MEMS), particularly, to RF MEMS switches comprising multilayer membranes.

### Background of the invention

Micro Electromechanical Systems (MEMS) are used in a very broad diversity of applications, as sensors, actuators or passive devices. RF MEMS in particular are used in radio frequency applications such as radio transmission, and in various industries such as mobile telecommunications. In mobile phones for example, RF MEMS can be used in the RF front-end for antenna tuning or antenna switching. MEMS components offer for those applications strong technical advantages such as very low insertion losses, high isolation in the case of switches, and very high linearity (over 70 dB in IIP3) compared to other technologies such as solid state devices.

More specifically regarding RF MEMS switches, the actuation principle remains the same in all existing art: a conducting transmission line is either opened or closed by means of an electromechanical actuation. The closing of the transmission line can be made for example using a conducting element featured on a beam, a bridge or a membrane located at short distance from two conductive ends of the transmission line separated one from the other in order to avoid electric conduction in the transmission line. The beam, the bridge or the membrane can be then electromechanically actuated so that the featured conductive element shorts the circuit between the two conductive ends of the transmission line through Ohmic contact for example, thus creating a conductive line and therefore closing the switch.

As mentioned before, the part supporting the conductive element can be either a beam (anchored at one end), a bridge (anchored on two ends) or a membrane (either free or featuring several anchors). According to an embodiment, the membrane can be completely free and maintained by pillars and stoppers (cf. EP 1 705 676 A1 and EP 2 230 679 A1).

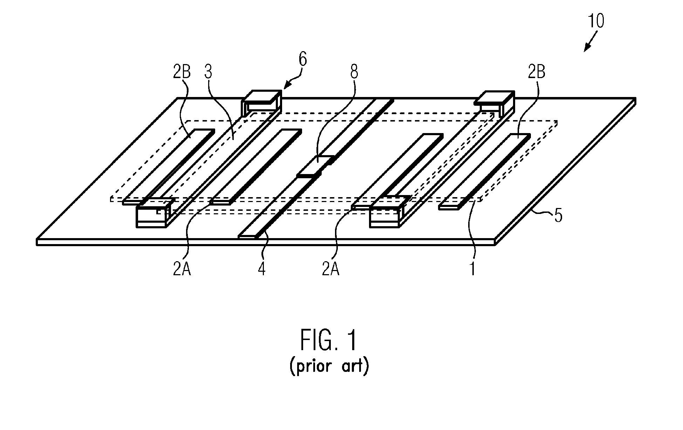

An example of a known MEMS switch structure comprising a freely supported membrane is illustrated in Figure 1. In order to bend the freely supported membrane 1, the MEMS structure 10 comprises electric actuation means that are adapted to bend the flexible membrane in order to lower the functional part of the membrane. The functional part of the membrane is a conductive element 8 featured under the part of the membrane in-between the two posts and that shorts the transmission line in closed mode. The electric lowering actuation means are typically constituted by external actuation electrodes 2A located under the membrane 1 that are adapted to exert electrostatic pulling forces directly to the membrane 1 in-between the posts when an actuation voltage is applied on the electrodes 2A. Theses pulling forces combined with a lever effect on the posts 3 enable to bend the membrane 1.

By the bent membrane Ohmic contact to a transmission line 4 is realized thanks to the contact featured under the membrane. The transmission line 4 may be adapted to transmit an RF signal. In the shown example the electrodes 2, posts 3 and the transmission line 4 are formed on the same substrate 5. In order to come back to the rest position or to go in isolation position (a position where the gap between the conductive element and the conductive plots is maximal), actuation voltage of electrodes 2A goes back to 0 and actuation voltage is applied to external electrodes 2B which will perform a lever effect with the posts 3 thus bending the membrane the other way. It is noted that the freely supported membrane switch can also function as a capacitive contact switch rather than an Ohmic contact one.

One of the most important specifications of an MEMS switch as described with reference to Figure 1 is its insertion loss. Despite the recent engineering process conventional MEMS devices show significant insertion losses. Therefore, it is an object of this application to provide for an improved MEMS device and a method of manufacturing of the same wherein the insertion losses can be reduced as compared to the art.

### Description of the Invention

The above-mentioned object is addressed by a method of manufacturing an MEMS device, in particular, an MEMS switch, comprising the steps of forming posts and a conduction (transmission) line over a substrate and forming a membrane over the posts and the conduction line. The step of forming the membrane comprises forming a first membrane layer and forming a second membrane layer over the first membrane layer in a region over one of the posts (in particular, over all posts) and/or a region over the conduction line such that the second membrane layer only partially overlaps the first membrane layer. The step of forming the membrane may comprise forming a first membrane layer and forming a second membrane layer over the first membrane layer in a region over one of the posts (in particular, over all posts) and/or a region over the conduction line such that the first membrane layer has a region where the second membrane layer is not formed adjacent to the region where the second membrane layer is formed. Thus, the second membrane layer is locally formed over the first membrane layer in order to stiffen regions of the membrane over the posts/conduction line. Particularly, the step of forming the membrane may comprise forming a first membrane layer and a second membrane layer over the first membrane layer only in regions over the posts and/or the conduction line (particularly, when the membrane is at rest without being bowed by any actuators).

The second membrane layer may be formed in the shape of one or more stripes. It is essential that the second membrane layer is formed locally over the first membrane layer, i.e., the second membrane layer not fully covers the first membrane layer but covers it over dedicated portions related to the posts and/or conduction line. The second membrane layer may be formed of the same material as the first one and may have the same thickness as the first one or a different thickness. The locally formed second membrane layer provides an enhanced stiffness/thickness of the membrane at the regions of the posts and/or conduction line. Thereby, insertion losses can be reduced due to an improved transformation of electrostatic force into contact force and switching speed can be increased due to improved transfer of mechanical forces thereby improving the overall performance of the MEMS device.

The second membrane layer may fully or partly extend over the entire transvers dimensions of the posts and/or the conduction line and/or may partly or fully cover the entire longitudinal widths of the posts and/or the conduction line. Herein, the term "longitudinal" refers to the longitudinal axis of the membrane whereas the term "transverse" refers to the transverse axis of the same. The second membrane layer may overlap the posts and/or transmission line (conduction line) in the width directions of the same by some amount, for example, the overlap may be below 2 widths or 1 widths of the posts/transmission line. The second membrane layer may be formed in a region extending along the entire length of a post or only partly along the post and may cover the post completely or partly and have a width in the range of ¼ to 4 times the width of the post. The second membrane layer may be formed in a region extending along the entire (transverse) length of a transmission line or only partly along the transmission line and may cover the transmission line completely or partly and have a width in the range of ¼ to 4 times the width of the transmission line or larger.

According to an embodiment, the method may further comprise forming a third membrane layer between the first membrane layer and the second membrane layer, wherein the third membrane layer comprises lateral recesses exposing lateral portions of the first membrane layer, and forming stoppers to restrict movement of the first membrane layer. The lateral portions of the first membrane layer exposed by the third membrane layer may be covered by any other material layer, in principle. The recesses may be arranged in the longitudinal direction of the membrane at edges of the third membrane layer (see also detailed description below). The stoppers may be arranged to contact edges of the first membrane layer in the recesses of the third membrane layer during operation of the MEMS device.

In operation, the first membrane layer may contact the stoppers that partly may extend into the recesses of the third membrane layer without contacting the third membrane layer when in contact with the first membrane layer. The free moving distance of the membrane is given by the gap between the stoppers and the edges of the first membrane layer. Since the first membrane layer can be provided thinner than a conventionally used membrane of uniform thickness the free moving distance of the membrane can be reduced as compared to the art thereby improving reliability of operation.

According to an embodiment, the first membrane layer is formed over a sacrificial base layer and the method further comprises forming a sacrificial layer over the first membrane layer and over parts of the sacrificial base layer not covered by the first membrane layer and in this embodiment the method comprises the forming of the stoppers comprises forming a stopper layer over the sacrificial layer and patterning the stopper layer to form the stoppers. The sacrificial base layer is also removed after or before or simultaneously to removal of the sacrificial layer. After removal of the sacrificial base layer the membrane may fall on posts formed over the substrate.

Examples of the inventive method may further comprise removing the sacrificial layer from a portion of the first membrane layer and forming the third membrane layer over the portion of the first membrane layer exposed by the removing process. The stopper layer and the stoppers may be formed before removing the sacrificial layer over the portion of the first membrane layer.

Herein, it is also considered the problem of undesirably attacking the first membrane layer during the process of patterning the third membrane layer or removing an electroplating seed layer from the sacrificial layer in the context of an electroplating process used for the formation of the stoppers and third membrane layer (see also detailed description below). Due to some mismatch between the sacrificial layer and the first membrane layer there is a risk that the first membrane layer is attacked by an etching process needed before removal of the sacrificial layer. In order to avoid this risk overhanging portions of the third membrane layer overhanging the recesses of the third membrane layer are formed.

The above-described examples of the inventive method may comprise accordingly, forming an overhanging portion of the third membrane layer over a recess of the lateral recesses of the third membrane layer. In particular, the method may comprise the steps of forming the first membrane layer over a sacrificial base layer, forming a sacrificial layer over the first membrane layer and over parts of the sacrificial base layer not covered by the first membrane layer, removing the sacrificial layer from a portion of the first membrane layer and forming an electroplating seed layer over the portion of the first membrane layer and the remaining sacrificial layer. Subsequently, a mold is formed over the electroplating seed layer exposing the electroplating seed layer over the portion of the first membrane layer and portions of the electroplating seed layer adjacent to the portion of the first membrane layer and electrodeposition of a material layer (providing the stoppers and third membrane layer) on the electroplating seed layer by electroplating using the mold is performed. Subsequently, the mold is removed, the electroplating seed layer over the portion of the first membrane layer is removed and the sacrificial layer is removed.

Alternatively, the examples of the inventive method may comprise the steps of forming the first membrane layer over a sacrificial base layer, forming a sacrificial layer over the first membrane layer and over parts of the sacrificial base layer not covered by the first membrane layer, removing the sacrificial layer from a portion of the first membrane layer and forming the third membrane layer over the portion of the first membrane layer and portions of the sacrificial layer adjacent to the portion of the first membrane layer.

The process of forming the overhanging portions can be performed independently from the process of providing the locally formed second membrane layer. Thus, it is provided a method of manufacturing an MEMS device, in particular, an MEMS switch or capacitor, comprising the steps of forming a first membrane layer over a sacrificial base layer, forming an additional membrane layer (comparable to the third membrane layer described in the context of the above examples comprising a locally thickened membrane) over the first membrane layer, wherein the additional membrane layer comprises lateral recesses exposing lateral portions of the first membrane layer That, however, may be covered by any other material layer), wherein forming of the additional membrane layer comprises forming an overhanging portion of the additional membrane layer over a recess of the lateral recesses of the additional membrane layer. This method of manufacturing the MEMS device without local thickening/stiffening by means of an additional locally formed membrane layer may comprise the steps of forming the first membrane layer over a sacrificial base layer, forming a sacrificial layer over the first membrane layer and over parts of the sacrificial base layer not covered by the first membrane layer, removing the sacrificial layer from a portion of the first membrane layer and forming an electroplating seed layer over the portion of the first membrane layer and the remaining sacrificial layer.

Subsequently, a mold is formed over the electroplating seed layer exposing the electroplating seed layer over the portion of the first membrane layer and portions of the electroplating seed layer adjacent to the portion of the first membrane layer and electrodeposition of a material layer on the electroplating seed layer by electroplating using the mold is performed thereby providing for the above-described third membrane layer and the stoppers, for example). Subsequently, the mold is removed, the electroplating seed layer over the portion of the first membrane layer is removed and the sacrificial layer is removed.

Alternatively, the examples of the inventive method may comprise the steps of forming the first membrane layer over a sacrificial base layer, forming a sacrificial layer over the first membrane layer and over parts of the sacrificial base layer not covered by the first membrane layer, removing the sacrificial layer from a portion of the first membrane layer and forming the additional membrane layer (comparable to the third membrane layer described in the context of the above examples comprising a locally thickened membrane) over the portion of the first membrane layer and portions of the sacrificial layer adjacent to the portion of the first membrane layer.

According to an exemplary embodiment it is provided an MEMS device, in particular, an MEMS switch, in order to address the above-mentioned object. The MEMS device comprises posts and a conduction (transmission) line formed over a substrate and a membrane over the posts and the conduction line. The membrane comprises a first membrane layer and a second membrane layer formed over the first membrane layer in a region over one of the posts and/or a region over the conduction line such that the second membrane layer only partially overlaps the first membrane layer. In particular, the first membrane layer may have a region where the second membrane layer is not formed adjacent to the region where the second membrane layer is formed. The second membrane layer may comprise one or more stripes or other patches locally formed over the first membrane layer. In particular, the second membrane layer may be formed only in regions over the posts and/or conduction line.

According to an embodiment of the MEMS device the second membrane layer fully or partly extends over the entire transvers dimensions of the posts and/or the conduction line and/or partly or fully covers the entire longitudinal widths of the posts and/or the conduction line. The second membrane layer may overlap the posts and/or transmission line (conduction line) in the width directions of the same by some amount, for example, the overlap may be below 2 widths or 1 widths of the posts/transmission line. The second membrane layer may be formed in a region extending along the entire (transverse) length of a post or only partly along the post and may cover the post completely or partly and have a width in the range of ¼ to 2 times the width of the post. The second membrane layer may be formed in a region extending along the entire (transverse) length of a transmission line or only partly along the transmission and may cover the transmission line completely or partly and have a width in the range of ¼ to 2 times the width of the transmission line or larger.

The MEMS device may further comprise a third membrane layer between the first membrane layer and the second membrane layer, wherein the third membrane layer comprises lateral recesses exposing lateral portions of the first membrane layer; and stoppers configured to restrict movement of the first membrane layer. The lateral portions of the first membrane layer exposed by the third membrane layer may be covered by any other material layer, in principle. Particularly, the stoppers may be arranged to contact edges of the first membrane layer in the recesses of the third membrane layer during operation of the MEMS device.

According to another embodiment, the third membrane layer of the MEMS may comprise an overhanging portion over a recess of the lateral recesses of the third membrane layer. The third membrane layer may comprise overhanging portions extending over all of the recesses, for example.

Additional features and advantages of the present invention will be described with reference to the drawings. In the description, reference is made to the accompanying figures that are meant to illustrate preferred embodiments of the invention. It is understood that such embodiments do not represent the full scope of the invention.
Figure 1 illustrates an MEMS switch of the art.
Figures 2a to 2c illustrate examples of operation states of an MEMS switch comprising a membrane showing localized thickened portions according to the present invention.
Figures 3a to 3e illustrate a method of manufacturing of an MEMS switch comprising the formation of stoppers and a three-layer membrane according to an example of the present invention.
Figures 4a to 4c illustrate a method of manufacturing of an MEMS switch comprising the formation of stoppers and a three-layer membrane according to another example of the present invention.
Figures 5a to 5c illustrate a method of manufacturing of an MEMS switch comprising the formation of stoppers and a three-layer membrane wherein a second membrane layer comprises overhanging portions according to an example of the present invention.
Figures 6a to 6e illustrate a method of manufacturing of an MEMS switch comprising the formation of stoppers and a three-layer membrane wherein a second membrane layer comprises overhanging portions according to another example of the present invention.
Figure 7 shows a top view of the configuration shown in Figure 3e and 4c and 5c.

Herein, it is described a method of manufacturing of an MEMS device, in particular, an MEMS switch, comprising a movable membrane with localized thickened portions. The membrane may be formed of a conductive alloy or metal. The MEMS device, in principle, can be a capacitive or Ohmic contact MEMS switch.

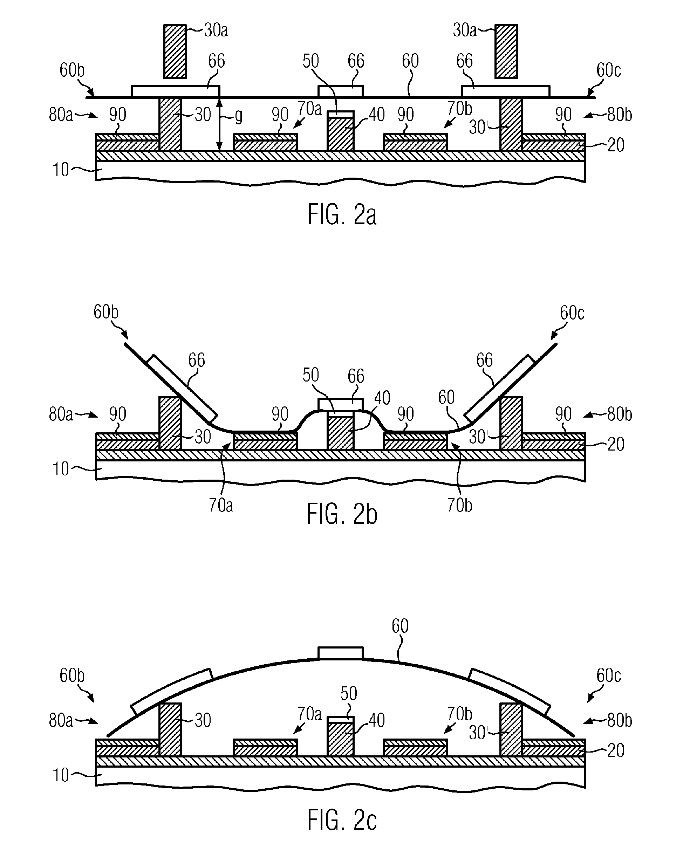

Referring to Figures 2a to 2c, according to an example of the present invention an MEMS switch comprises a wafer 1 (for example made of silicon) forming the substrate of the switch. A thin dielectric layer 20, as passivation layer, is deposited onto the surface of said wafer 10. On the dielectric layer 20, the switch comprises: two lateral pillars (posts) 30, 30' that are spaced-apart in the longitudinal direction X, each pillar 30, 30' extending in the transverse direction of Figure 2a, one central pillar (post) 40 that extends in the transverse direction Y, said central pillar 40 being positioned between the two lateral pillars 30, 30', for example, at the center between pillars 30, 30', and a membrane comprising membrane layer 60. The top surface of the central pillar 40 may be covered by a thin dielectric layer 50 for a capacitive switch configuration. However, for an Ohmic switch direct contact of a conductive part under the membrane layer 60 and central pillar is needed, i.e., the dielectric layer 50 is omitted as well as the representation of the separation of the transmission line into two lines apart from each other that are shorted by a contact under the membrane in closed state.

The two lateral pillars 30, 30' and the central pillar 40 form a Coplanar Waveguide (CPW), the two lateral pillars 30, 30' corresponding to the ground lines. The central pillar 40 forms the signal line (transmission line) for the transmission of an RF electric signal within the coplanar waveguide (CPW). In another variant, the RF signal line can be also implemented by mean of a microstrip waveguide. The lateral pillars 30, 30' and the central pillar 40 are for example made of a metal such as gold or gold alloy.

The MEMS switch further comprises a switch element which is constituted by a thin flexible membrane 6. Said flexible membrane comprising membrane layer 60 is moveably positioned above the pillars 30, 30', 40. The longitudinal axis of the membrane layer 60 is parallel to aforesaid longitudinal direction X and perpendicular to aforesaid transverse direction Y. Both ends 60b, 60c of the membrane layer 60 are not clamped on the substrate 10, and the membrane is thus freely supported at rest (Figure 2a) by the pillars 30, 30'. In the variant of Figure 1a, the flexible membrane layer 60 is spaced apart from the central pillar 40, and is thus not supported at rest by said central pillar 40. In another variant, the flexible switch membrane layer 60 could be supported at rest by the central pillar 40. The flexible membrane layer 60 is made of metal, for example, such as aluminum, gold, or any conductive alloy. In the shown example, the MEMS switch also comprises stoppers 3a that are positioned above each lateral pillar 30, 30', and form a passage through which the central part of the membrane layer 60 is freely positioned. These stoppers are shown in Figure 2a and for sake of clarity are not shown in Figures 2b and 2c. These stoppers 30a are used for maintaining the membrane 6 on the lateral pillars 30 and 30', but without hindering the membrane layer 60 from freely moving relatively to the lateral pillars 30 during normal use of the switch.

The MEMS switch further comprises electrostatic lowering actuating means 70 that are used for bending down longitudinally the membrane layer 60 into the down forced state of Figure 2b, and electrostatic raising actuating means that are used for bending up longitudinally the membrane layer 60 into the up forced state of Figure 2c.

The electrostatic lowering actuating means are formed by two internal electrodes 70a, 70b, that are positioned under the functional part of the membrane layer 60. The internal electrodes 70a extends between the lateral pillar 30 and the central pillar 40. The internal electrodes 70b extends between the central pillar 40 and the lateral pillar 30'. The electrostatic raising actuating means comprises two external electrodes 80a, 80b. When the switch is a RF capacitive switch, the top surface of each electrode 70a, 70b 80a, 80b is covered by a dielectric layer 90 (Figure 2a) in order to avoid any Ohmic contact between the membrane layer 60 and the electrodes. However, the dielectric layers 90 may be omitted as some embodiments feature protective bumps in order to avoid direct contact.

When no actuation voltage is applied on the electrodes 70a, 70b, 80a and 80b, the membrane layer 60 of the switch is in the rest position of Figure 2a. In this rest state, the membrane layer 60 is substantially planar and is supported by the pillars 30, 30', with a predetermined gap g between the membrane layer 60 and the substrate 1. In another variant, the membrane could be bended at rest. When an actuation voltage is applied on the internal electrode 70a, 70b, electrostatic pulling forces are generated within actuation area and are pulling down the functional part of the membrane layer 60 between the posts 30, 30'. These pulling forces are bending down (in the negative Z-direction) the membrane layer 60 into the down forced state of Figure 2b. In this down forced state, due to a lever effect on the pillars 30 and 30', the gap Gint between the substrate 10 and each end 60b, 60c of the membrane layer 60 is large, and in particular is larger than gap g in the rest state. In order to move the membrane 6 from the down forced state of Figure 2b to the up forced state of Figure 2c, no actuation voltage is applied on electrodes 70a and 70b and simultaneously an actuation voltage is applied on the electrodes 80a, 80b. Electrostatic forces are generated within a raising actuation area and are pulling down the non-functional parts of the membrane layer 60 outside the pillars 30, 30'. More especially, electrostatic pulling down forces are exerted on each non-functional parts of the membrane layer 60 simultaneously on both sides of each lateral pillar 30 or 30' in the negative Z-direction. In another variant, for moving the membrane layer 60 from the down forced state to the up forced state, in a first step an actuation voltage can be applied on the electrodes 80a, 80b, while maintaining the actuation voltage on electrodes 70a, 70b. Then in a second step, after a predetermined duration (for example, a duration corresponding to the switching time of the switch), no actuation voltage is applied on electrodes 70a and 70b.

Thus far, the description has followed the description of the MEMS device of EP 2 230 679 B1. In fact, similar shapes for the membrane can be chosen as disclosed in EP 2 230 679 B1. However, the inventive example illustrated in Figures 2a to 2c differs from the MEMS device described in EP 2 230 679 B1 by the provision of an additional membrane layer 66 that is locally formed over (for example, on) the membrane layer 60 thereby resulting in a locally thickened/stiffened membrane. The additional membrane layer 66 is formed in regions over the pillars 30, 30' and central pillar (transmission line) 40 and enhances mechanical stability of the membrane. It may extend along the entire transvers dimensions of the pillars 30, 30' and central pillar 40. The widths (in longitudinal direction) of the additional membrane layer 66 may exceed the widths of the pillars 30, 30' and central pillar 40, respectively. The additional membrane layer 66 may be made of the same material as the membrane layer 60.

In Ohmic MEMS switches, the transmission is made through a metal contact (at pillar 40), and the stronger the contact force, the higher the conductivity and the lower the insertion losses of the switch are. Physically, this is explained by the fact that at nanoscale level, the contact between contact electrodes (for example, transmission line 40) is not uniform but is made by several asperities of a rough contact surface. Due to that, increasing the force on the contacts allows for a larger contact area as more asperities will be in direct physical contact. In Ohmic switches, the contact force is directly linked to the electrostatic force applied by the electrodes. This electrostatic force is intrinsically limited by several aspects of the switch such as the limited electrode size, the contact structure and the limited actuation voltages. Therefore in order to increase the contact forces and to reduce insertion losses, optimization of the membrane structure is proposed herein. By locally increasing the stiffness of the membrane due to the additional membrane layer 66 formed over membrane layer 60 it is possible to optimize the force transfer between the external actuation electrodes 70a, 70b, 80a, 80b and the contact (transmission line) 40 and to increase the mechanical force applied to the contact 40.

As shown in Figures 2a to 2c there are parts of the membrane that do not bend much (typically over the pillars 30, 30') and parts where strong bending is required (over the electrodes 70a, 70b, 80a, 80b). The parts of the membrane where the lowest deformation occurs (over the pillars 30, 30') are thickened, whereas parts where high deformation occurs are kept with low stiffness. Equally, a thickening has been performed over the contact 40. The local thickening is provided by the additional membrane layer 66 formed over membrane layer 60. The thickening over the pillars 30, 30' allows for a better force transfer between the external electrodes 80a, 80b and the inner (functional) part of the membrane. The stiffer the membrane is formed, the higher the mechanical coupling is. This permits a good force transfer from one side of the pillar 30, 30' to the other side of it. The parts of the membrane where high deformation is required are not thickened (no additional membrane layer is formed on those parts of membrane layer 60) in order to keep the desired overall flexibility of the membrane. In this example, only low deformation parts are stiffened in order not to impact this flexibility. The part over the contact 40 is thickened by the additional membrane layer 66 in order to increase the contact force in a closed position. In a closed position, the deformation is forced at the contact level. The electrostatic force applied by the electrode 70a, 70b is transformed at the contact level into contact force and deformation force. By increasing the stiffness over the contact 40, the deformation force is reduced and therefore the contact force increased. This permits an optimization of the use of the electrostatic force applied by increasing the contact force without affecting the electrostatic force.

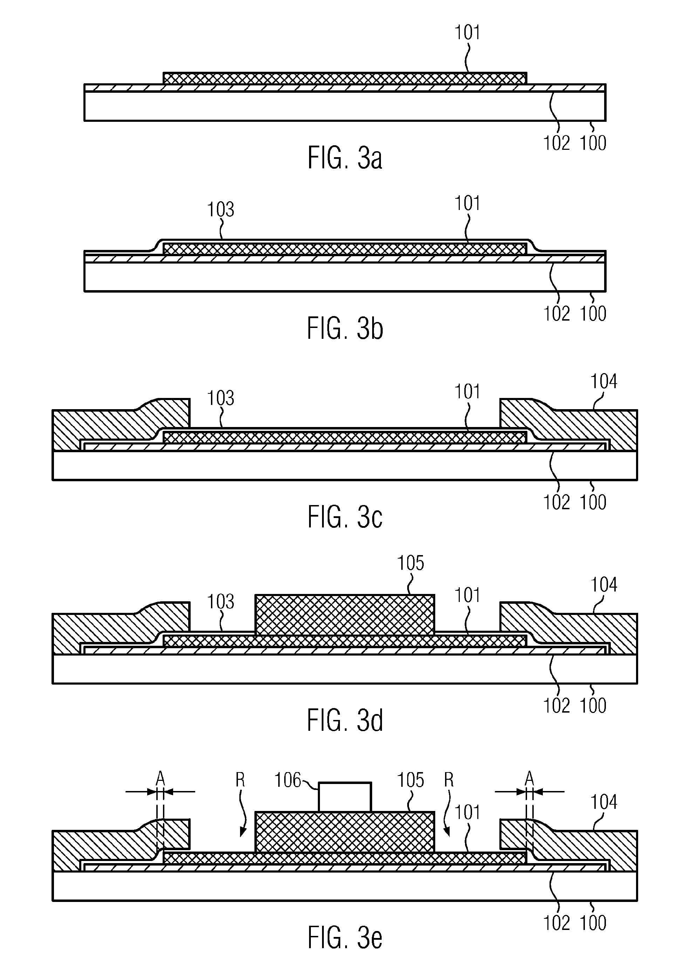

An example for the manufacture of an MEMS device comprising a three-layer membrane according to the invention is illustrated in Figures 3a to 3c.

As shown in Figure 3a a first membrane layer 101 is formed over a sacrificial base layer 102. The sacrificial base layer 102 is formed over layer 100. In the following, for exemplary purposes, it is assumed that layer 100 represents a post (confer Figures 2a to 2c) formed on a substrate. The finally produced membrane will rest on the post (see description below). A sacrificial layer 103 is formed over the first membrane layer 101 and the sacrificial base layer 102 over portions not covered by the first membrane layer 101 (see Figure 3b). The sacrificial layer 103 may be formed, for example, by spin-coating, of a polymeric or dielectric material.

A stopper layer is formed over the sacrificial layer 103 and etched in order to form stoppers 104 that are connected to layer 100 (see Figure 3c). Next, the sacrificial layer 103 is etched over a major portion of the first membrane layer 101. After the etching process the sacrificial layer 103 is only maintained over relatively small lateral regions of the first membrane layer 101. Over the exposed major portion of the first membrane layer 101, a third membrane layer 105 is formed (see Figure 3d). It is noted that the third membrane layer 105 is not necessarily exactly centered on the first membrane layer 101. The surface area of the first membrane layer 101 may be larger or smaller than the one of the third membrane layer 105 formed thereon. The third membrane layer 105 may be formed of the same material as the first membrane layer 101, for example, of an electrically conductive alloy or metal material (comprising aluminium or gold for example). Both the first membrane layer 10 and the third membrane layer 105 may comprise sub-layers. Both the stopper layer and the third membrane layer 105 may be formed by deposition.

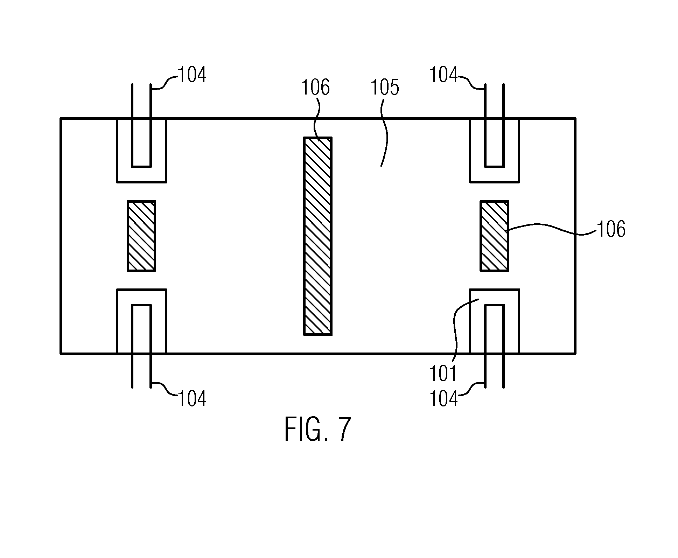

As it is illustrated in Figure 3e the sacrificial layer 103 is removed, for example, by reactive ion etching or plasma etching. The resulting third membrane layer 105 shows lateral recesses R arranged over lateral portions of the first membrane layer 101 where the sacrificial layer 103 is removed. Moreover, the sacrificial base layer 102 is removed. The sacrificial layer 103 and the sacrificial base layer 102 may be removed during one etching process, for example, or they may be removed one after the other. After removal of the sacrificial base layer 102 the freely moveable membrane comprising the first and third membrane layers 101 and 105 falls on layer 100 (not shown in Figure 3e). The stoppers 104 are arranged to contact edges of the first membrane layer 101 within the recesses of the third membrane layer 105 without contacting the third membrane layer 105 (confer also Figure 7 showing a top view of the configuration comprising the first and third membrane layers 101 and 105 and stoppers 104 that are partly arranged within the recesses of the third membrane layer 105). When contacting the first membrane layer 101 with some part a stopper does not contact the third membrane layer 105 with a part extending into a recess R of the third membrane layer 105. The resulting lateral free moving space (distance) depends on the thickness of the sacrificial layer 103. In total, the lateral free moving distance adds up to 2A (see Figure 3e). According to a particular example, 2A does not exceed about 1 µm. For example, the first membrane layer 101 has a thickness of about 1 µm, the thickness of the third membrane layer 105 is about 2 µm or more and the thickness of the sacrificial layer 103 is about 0.5 µm.

Contrary to the art, according to the present invention the membrane comprises a thicker portion and thinner portions at the recesses R of the third membrane layer 105. The thinner portions allow for a thinner sacrificial layer 103 resulting in a smaller lateral free moving space (distance) of the movable (freely supported) membrane as compared to the art. The smaller lateral free moving space allows for a more reliable operation of the resulting MEMS switch.

An additional second membrane layer 106 is formed on the third membrane layer 105. The second membrane layer 106 may be formed over posts and/or a transmission (conduction) line (confer additional membrane layer 66 of Figures 2a to 2c). The second membrane layer 106 when provided over a transmission (conduction) line can give rise to an enhancement of the contact force thereby resulting in an improved efficiency of the switching process. When formed over posts whereon the freely moving membrane rests the second membrane layer 106 improves the force transfer on the posts thereby allowing for an acceleration of the switching process.

In the example shown in Figures 3a to 3e the third membrane layer 105 is formed subsequently to the formation of the stoppers 104. However, the configuration shown in Figure 3e can be formed in different ways. In particular, the third membrane layer 105 and the stoppers 104 can be formed simultaneously. The thicknesses of these layers may be the same or may differ from each other.

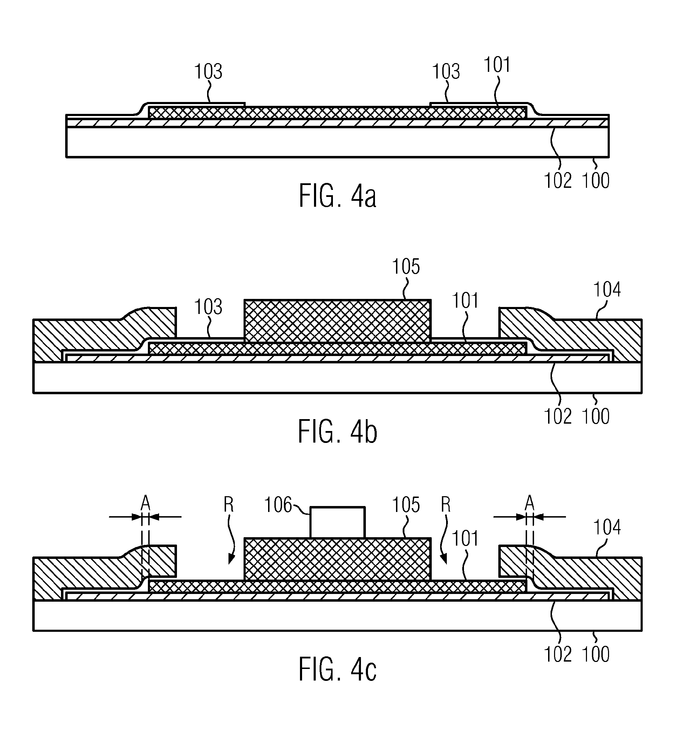

According to the example shown in Figure 4a the configuration shown in Figure 3b is etched to remove the sacrificial layer 103 over a major portion of the first membrane layer 101 before the formation of the stoppers 104. The sacrificial layer 103 is maintained on distinct lateral regions of the first membrane layer 101. Again, the sacrificial layer 103 may be formed of a polymeric or dielectric material and may be etched by reactive ion etching, for example. A third membrane layer 105 is formed over the first membrane layer 101 in the etched region. Moreover, a stopper layer is formed over the sacrificial layer 103 and etched in order to form stoppers 104 connected to layer 100 (see Figure 4b). For example, the stoppers 104 and the third membrane layer 105 may be formed of the same material that may be a metal material or an electrically conductive alloy. For example, the stoppers 104 and the third membrane layer 105 may be formed in the same processing step. The processing step may comprise some deposition techniques as known in the art. The deposition techniques may involve deposition of an electroplating seed layer followed by electroplating of a material layer that subsequently is patterned to form the third membrane layer 105 and stopper 104, for example.

After formation of the stoppers 104 and third membrane layer 105 the sacrificial layer 103 is removed (Figure 4c). Moreover, sacrificial base layer 102 is removed such that the membrane comprising the first and third membrane layers 101 and 105 can fall on layer (post) 100. The sacrificial base layer 102 and sacrificial layer 103 can be removed after the creation of the last membrane level 106.. Similar to the example shown in Figure 3e a smaller lateral free moving space (distance) 2A of the movable (freely supported) membrane as compared to the art results. An additional second membrane layer 106 is formed on the third membrane layer 105. The second membrane layer 106 may be formed over posts and/or a transmission (conduction) line (confer additional membrane layer 66 of Figures 2a to 2c).

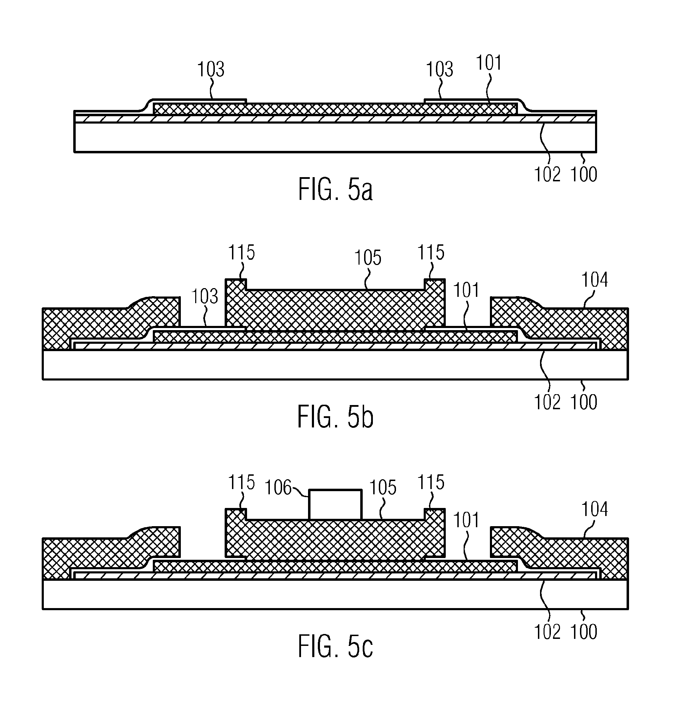

A modified version of the example illustrated in Figures 4a to 4c is shown in Figures 5a to 5c. Different from the example shown in Figures 4a to 4c the third membrane layer 105 comprises overhanging portions 115 extending in the direction of the recesses of the third membrane layer 105. In order to arrive at the structures shown in Figure 4b a material layer may be continuously formed over the structure shown in Figure 4a, covered by a patterned mask and etched in order to achieve the stoppers 104 and third membrane layer 105.

However, the material layer has to be over-etched to some degree above the sacrificial layer 103 in order to guarantee that the sacrificial layer 103 can be properly removed in the further proceedings. Due to some mismatch between the third membrane layer 105 and the sacrificial layer 103 there is a risk that the underlying first membrane layer 101 can be attacked (at the lower edges of the third membrane layer 105) during the etching of the material layer. This risk can be avoided by the formation of the overhanging regions 115 over the sacrificial layer 103 as it is shown in Figures 5b and 5c. In principle, the manufacturing process shown in Figures 5a to 5c may or may not involve formation of a second membrane layer 106.

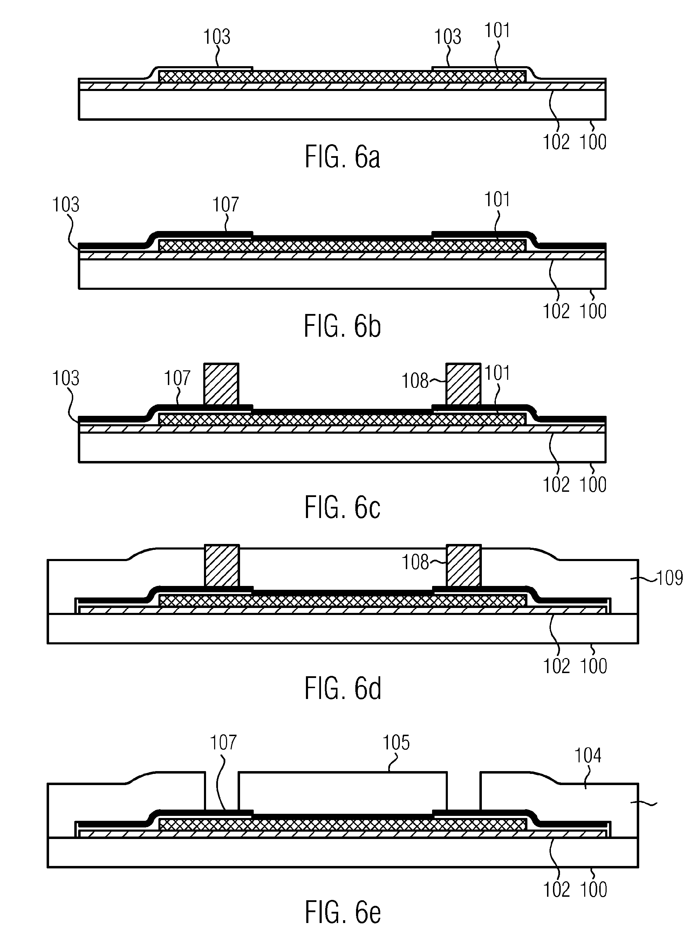

Another example for the manufacture of an MEMS device comprising a membrane with a third membrane layer 105 comprising overhanging regions 115 is shown in Figures 6a to 6e. In the shown example, electroplating is used for forming the stoppers 104 and third membrane layer 105. For example, the stoppers 104 and third membrane layer 105 are formed of gold. In Figure 6a the configuration shown in Figure 3b is etched to remove the sacrificial layer 103 over a major portion of the first membrane layer 101. The sacrificial layer 103 is maintained on distinct lateral regions of the first membrane layer 101 formed over the sacrificial base layer 102 that is formed on layer 100 (for example, a post, cf. Figures 1 and 2a to 2c). A thin electroplating seed layer 107 (for example, a thin gold layer) is formed over the structure shown in Figure 6a. Next, a mold 108 is formed on the thin electroplating seed layer 106 (Figure 6c). The mold 108 is used for the subsequently electroplating process. It should be stressed that the mold 108 exposes a portion of the electroplating seed layer 106 formed over the sacrificial layer 103 adjacent to the portion of the electroplating seed layer 106 formed over the first membrane layer 101. This exposed portion will result in an overhanging portion of the third membrane layer 105 as illustrated in Figure 5c.

Material layer 109 is formed by electroplating using the mold 108 as illustrated in Figure 6d. After removal of the mold 108 the resulting stoppers 104 and third membrane layer 105 can be seen in Figure 6e. Before removal of the sacrificial layer 103 the thin electroplating seed layer 107 formed on the sacrificial layer 103 and below the mold 108 used in the electroplating process has to be removed. As described with reference to Figures 5a to 5c there may be some mismatch between the third membrane layer 105 and the sacrificial layer 103. However, in the shown exemplary manufacturing process there is no risk that the underlying first membrane layer 101 can be attacked (at the lower edges of the third membrane layer 105) during the etching of the electroplating seed layer. This risk, in fact, is avoided by the formation of the overhanging regions 115 over the sacrificial layer 103 as it is shown in Figure 6e. After forming the second membrane layer 106 and removing the sacrificial layer 103 a configuration similar to the one illustrated in Figure 5c results.

In principle, the manufacturing process shown in Figures 5a to 5c and 6a to 6e may or may not involve the formation of the second membrane layer 106.

A top view of the configuration shown in Figure 3e, 4c and 5c is shown in Figure 7. A second membrane layer 106 is formed over regions of the third membrane layer 105 over posts whereon the membrane rests and a conduction line contacted by a conductive part featured under the membrane during a switching process. The posts and the conduction line extend in the transverse direction (up-down). The second membrane layer 106 may completely or partially overlap the posts and/or transmission line formed below the membrane in the longitudinal and/or transverse direction. Recesses are arranged along the longitudinal direction (from left to right). The overall surface area of the third membrane layer (105) may be larger or smaller than the one of the first membrane layer (101). The first membrane layer (101) may be shaped such that it does not extend over the entire regions of the recesses. Moreover, the shape of the membrane comprising the first and third membrane layers 101 and 105 may be varied. For example, additional recesses in both the first and third membrane layers 101 and 105 may be provided in the longitudinal direction. In particular, both the first and third membrane layers may comprises lateral recesses at a longitudinal position where the transmission line is located on the substrate of the MEMS device (confer Figures 2a to 2c).

All previously discussed embodiments are not intended as limitations but serve as examples illustrating features and advantages of the invention. It is to be understood that some or all of the above described features can also be combined in different ways.

## Claims

1. A method of manufacturing an MEMS device, in particular, an MEMS switch, comprising the steps of:
forming posts (30, 30', 100) and a conduction line (40) over a substrate (10); and
forming a membrane over the posts (30, 30', 100) and the conduction line (40) comprising forming a first membrane layer (60, 101) and forming a second membrane layer (66, 106) over the first membrane layer (60, 101) in a region over one of the posts (30, 30', 100) and/or a region over the conduction line (40) such that the second membrane layer (66, 106) only partially overlaps the first membrane layer (60, 101).

2. Method according to claim 1, wherein the second membrane layer (106) fully or partly extends over the entire transvers dimensions of the posts (30, 30', 100) and/or the conduction line (40) and/or partly or fully covers the entire longitudinal widths of the posts (30, 30', 100) and/or the conduction line (40).

3. Method according to claim 1 or 2, further comprising
forming a third membrane layer (105) between the first membrane layer (60, 101) and the second membrane layer (66, 106), wherein the third membrane layer (105) comprises lateral recesses (R) exposing lateral portions of the first membrane layer; and
forming stoppers (30a, 104) to restrict movement of the first membrane layer (60, 101).

4. Method according to claim3, wherein the stoppers are arranged to contact edges of the first membrane layer (60, 101) in the recesses (R) of the third membrane layer (105) during operation of the MEMS device.

5. Method according to one of the claims 3 or 4, wherein the first membrane layer (101) is formed over a sacrificial base layer (102) and further comprising forming a sacrificial layer (103) over the first membrane layer (101) and over parts of the sacrificial base layer (102) not covered by the first membrane layer (101) and wherein the forming of the stoppers (104) comprises forming a stopper layer over the sacrificial layer (103) and patterning the stopper layer to form the stoppers (104).

6. Method according to one of the claims 3 to 5, further comprising removing the sacrificial layer (103) from a portion of the first membrane layer (101) and wherein the third membrane layer (105) is formed over the portion of the first membrane layer (101) exposed by the removing process.

7. Method according to one of the claims 3 to 6, wherein the stopper layer and the stoppers are formed before removing the sacrificial layer (103) over the portion of the first membrane layer (101).

8. Method according to one of the claims 3 to 7, further comprising forming an overhanging portion (115) of the third membrane layer (105) over a recess (R) of the lateral recesses (R) of the third membrane layer (105).

9. Method according to claim 8, comprising
forming the first membrane layer (101) over a sacrificial base layer (102);
forming a sacrificial layer (103) over the first membrane layer (101) and over parts of the sacrificial base layer (102) not covered by the first membrane layer (101);
removing the sacrificial layer (103) from a portion of the first membrane layer (101);
forming an electroplating seed layer (107) over the portion of the first membrane layer (101) and the remaining sacrificial layer (103);
forming a mold (108) over the electroplating seed layer (107) exposing the electroplating seed layer (107) over the portion of the first membrane layer (101) and portions of the electroplating seed layer (107) adjacent to the portion of the first membrane layer (101);
electroplating a material layer on the electroplating seed layer (107) using the mold (108);
removing the mold (108);
removing the electroplating seed layer (107) over the portion of the first membrane layer (101); and
removing the sacrificial layer (103).

10. Method according to claim 8, comprising
forming the first membrane layer (101) over a sacrificial base layer (102);
forming a sacrificial layer (103) over the first membrane layer (101) and over parts of the sacrificial base layer (102) not covered by the first membrane layer (101);
removing the sacrificial layer (103) from a portion of the first membrane layer (101);
forming the third membrane layer (105) over the portion of the first membrane layer (101) and portions of the sacrificial layer (103) adjacent to the portion of the first membrane layer (101).

11. MEMS device, in particular, an MEMS switch, comprising
posts (30, 30', 100) and a conduction line (40) formed over a substrate (10); and
a membrane over the posts (30, 30', 100) and the conduction line (40);
wherein the membrane comprises a first membrane layer (60, 101) and a second membrane layer (66, 106) formed over the first membrane layer (60, 101) in a region over one of the posts and/or a region over the conduction line such that the second membrane layer (66, 106) only partially overlaps the first membrane layer (60, 101).

12. MEMS device according to claim 11, wherein the second membrane layer (106) fully or partly extends over the entire transvers dimensions of the posts (30, 30', 100) and/or the conduction line (40) and/or partly or fully covers the entire longitudinal widths of the posts (30, 30', 100) and/or the conduction line (40).

13. MEMS device according to claim 11 or 12, further comprising
a third membrane layer (105) between the first membrane layer (60, 101) and the second membrane layer (66, 106), wherein the third membrane layer (105) comprises lateral recesses (R) exposing lateral portions of the first membrane layer; and
stoppers (30a, 104) configured to restrict movement of the first membrane layer (60, 101).

14. MEMS device according to one of the claims 11 to 13, wherein the stoppers are arranged to contact edges of the first membrane layer (60, 101) in the recesses (R) of the third membrane layer (105) during operation of the MEMS device.

15. MEMS device according to one of the claims 11 to 14, wherein the third membrane layer (105) comprises an overhanging portion (115) over a recess (R) of the lateral recesses (R) of the third membrane layer (105).
